# Europäisches Patentamt

# European Patent Office

# Office européen des brevets

(11) Publication number: **0 139 638**
**B1**

# EUROPEAN PATENT SPECIFICATION

(45) Date of publication of patent specification: **18.01.89**

(51) Int. Cl.⁴: **G 01 R 31/12, G 01 R 27/02**

(21) Application number: **83901473.5**

(22) Date of filing: **14.03.83**

(86) International application number:
**PCT/US83/00374**

(87) International publication number:
**WO 84/03772 27.09.84 Gazette 84/23**

(54) **INSULATION ANALYZER AND METHOD.**

(43) Date of publication of application:
**08.05.85 Bulletin 85/19**

(45) Publication of the grant of the patent:
**18.01.89 Bulletin 89/03**

(84) Designated Contracting States:
**AT BE CH DE FR GB LI LU NL SE**

(56) References cited:
US-A-2 916 697
US-A-3 437 925
US-A-4 217 543

INTERNATIONALE ELEKTRONISCHE
RUNDSCHAU, vol. 26, no. 8, August 1972,
pages 184-188; F. WOLF: "Digital und analog
anzeigendes Tera-Ohmmeter mit
kontinuierlich einstellbarer Messspannung"

(73) Proprietor: **JAMES G. BIDDLE COMPANY**
**510 Township Line Road**
**Blue Bell, PA 19422 (US)**

(72) Inventor: **LESZCZYNSKI, Steven, A.**
**1404 Denise Circle**
**Phoenixville, PA 19460 (US)**
Inventor: **REYNOLDS, Peter, H.**
**1 Detweiler Lane**
**Ambler, PA 19002 (US)**

(74) Representative: **Newby, John Ross**
**J.Y. & G.W. Johnson Furnival House 14/18 High**
**Holborn**
**London WC1V 6DE (GB)**

Courier Press, Leamington Spa, England.

**Description**

The present invention relates to measurement of insulation resistance, and other related properties of a specimen. The apparatus and method claimed (claims 1 and 3) is a refinement and improvement of apparatus and method disclosed in U.S. Patent Cooperation Treaty patent application Serial No. 81/01647, filed December 14, 1981, the invention of Peter H. Reynolds. Using such improvements, it is able to achieve high accuracy over a wider range of measured parameters (see also Internationale Electronische Rundschau, Vol. 26, No 8, August 1972, pages 184—188; F. Wolf:" Digital and analog anzeigendes Tera-Ohmmeter mit Kontinuierlich einstellbarer Messpannung").

Background of the invention

The aforesaid Reynolds application made reference to the technical analysis of insulation testing entitled "Insulation Testing by D—C Methods" made in 1958 by E. B. Curdts which is revised and reprinted in 1964 in the Biddle Technical Publication 22T1. In that publication, Curdts showed that when d.c. voltage is applied, the current existing in the insulation of a capacitive specimen is always made up of three components, to wit: geometric capacitance current, $i_g$; absorption current, $i_a$; and conduction current, $i_c$. These currents are more fully explained in the referenced patent application. Conventional insulation testers were capable of only reading the algebraic sum of these currents ($I_{TOT}$) such that

$$I_{TOT} = i_g + i_a + i_c.$$

In 22T1, E. B Curdts described a method of calculating $i_c$ from $i_{TOT}$. The derived equation is

$$i_c = \frac{i_1(i_{10}) - i_{3.16}2}{i_1 + i_{10} - 2i_{3.16}}$$

where $i_1$, $i_{3.16}$ and $i_{10}$ are three different values of $I_{TOT}$ measured at different times, based on a constant unit of time multiplied by their subscripts, i.e., 1, 3.16 and 10 minutes. The equation assumed that the unit time chosen was long enough such that $i_g$, the geometric capacitance charging current, has become negligible. In application of this equation, however, some limitations may be encountered to which the following two case examples are illustrative.

In case 1, the time unit was chosen too long for a given specimen. This is possible since nothing is known about the specimen prior to test. Under these conditions $I_{TOT}$ at 1, 3.16 and 10 minute time units may be primarily composed of conduction current $i_c$ which remains constant with time. The net result is that $i_1$ approximates $i_{3.16}$ which approximates $i_{10}$. In placing these readings into the equation the denominator is a very small number having been derived by the subtraction of rather large numbers. As a result small errors in raw data can cause large variances in the calculated resultant $i_c$.

In case 2 the conduction current is, in fact, large relative to the other current components due to poor insulation characteristics. Again, the denominator will be small, making small error terms in the raw data dominate the calculated result, $i_c$.

Nature of the present invention

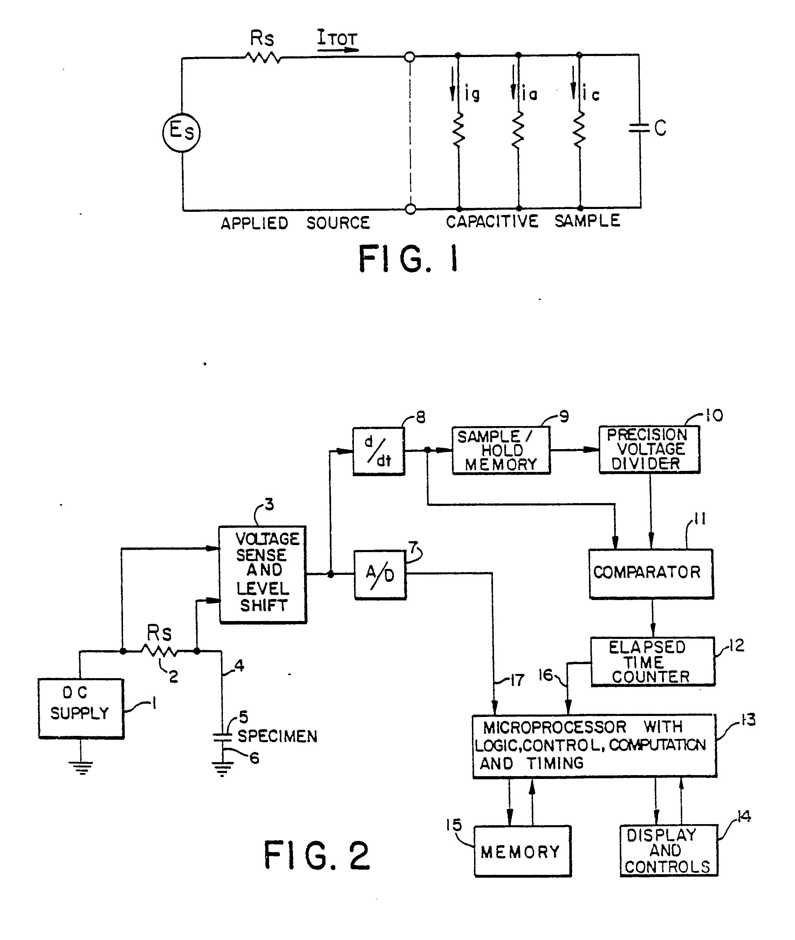

As stated earlier, the total current in a capacitive sample is made up of three components such that

$$I_{TOT} = i_g + i_a + i_c$$

as represented in the schematic circuit diagram of Fig. 1. The above equation can be approximated in the time domain by substitution for each current term, a formula representative of actual characteristics of each current type assuming a positive potential is applied to the specimen through a series resistance at time zero (t=0) by the following equation:

$$I_{TOT}(T) = \frac{E_s}{R_s} e^{-t/CR_s} + E_s(1 - e^{-t/CR_s})CD\ T^{-n} + i_c$$

where
$E_s$=the applied source voltage
$R_s$=total series resistance
$C$=the zero-frequency capacitance of the specimen
$t$=time (seconds)
$T$=large time units (i.e. minutes) $T \gg 4t$
$D$=a proportionality factor on a per unit basis of applied voltage and the capacitance of the specimen. This depends on the type of insulation and its condition and temperature,
$n$=a constant

2

It was further assumed that the series resistance was small in relation to the true insulation resistance.

If the analysis of restricted to many time constants (one time constant=$CR_s$), after t=0, then l(t) can be further reduced to:

$$I_{TOT}(T)=0+E_sCDT^{-n}+i_c=AT^{-n}+i_c$$

where $A=E_sCD$ and $T\gg4t$

At an arbitrary time when T=X

$$I_{TOT}(T=X)=AX^{-n}+i_c \tag{1}$$

Likewise at T=Y

$$I_{TOT}(T=Y)=AY^{-n}+i_c \tag{2}$$

Equations (1) and (2) can be simultaneously solved for $i_c$

$$i_c=\frac{Y^{-n}(I_{TOT}(T=X))-X^{-n}(I_{TOT}(T=Y))}{Y^{-n}-X^{-n}} \tag{3}$$

Therefore if the value of n were known, and the value of $I_{TOT}$ were measured at times T=X and T=Y, the value of $i_c$ could be determined. To resolve n, $I_{TOT}$ signal may be differentiated to obtain $I_{TOT}'$ such that

$$I_{TOT}'=\frac{dI_{TOT}(T)}{dt}=\frac{d}{dt}(AT^{-n}+i_c)=-nAT^{-(n+1)}$$

At the previously chosen time of T=X, the value of $I_{TOT}'$ is:

$$I_{TOT}'(T=X)=-nAX^{-(n+1)} \tag{4}$$

While at time (T=Z)

$$I_{TOT}'(T=Z)=-nAZ^{-(n+1)} \tag{5}$$

Since the magnitude of $I_{TOT}'(T)$ decreases with time, an arbitrary ratio R may be defined such that.

$$R=\frac{I_{TOT}'(T=Z)}{I_{TOT}'(T=X)} \qquad \text{Note. } R<1.0$$

By substitute of equations (4) and (5)

$$R=(Z/X)^{-(n+1)}$$

Solving for n:

$$n=(-\log R/\log(Z/X))-1.0 \tag{6}$$

As a demonstration of how an instrument can be constructed by application of the derivation above, consider one set of parameters herein chosen to reflect one set of practical value which may be implemented electronically. These values do not define the only practical values.

Let X=1 minute

Y=10 minutes

R=0.5

Z=a measured parameter.

If one electronically differentiates the function $I_{TOT}(T)$ and allows for a constant gain K to be produced by the differentiator, it can be mathematically shown that equation (6) remains unchanged. Let the value of $I_{TOT}'(T)$ be stored by electronic means at one minute (T=X) and by using a precision electronic divider, the stored value will be divided in half (R=0.5). Furthermore, let the instantaneous value of $I_{TOT}'(T)$ be compared by electronic means to the value of 0.5 $I_{TOT}'$ (T=1 minute) and record the time in minutes, via electronic means, until said signals are equal. (Solving for T=Z). Once Z has been determined the value of n can be accurately determined by:

$$n=(-\log 0.5/\log Z)-1.0$$

and consequently $i_c$ can also be determined accurately from

$$i_c = \frac{I_{TOT}(T=10)-10^{-n}(I_{TOT}(T=1))}{1-10^{-n}}$$

Drawings illustrating the invention

For a better understanding of the present invention, reference is made to the accompanying drawings in which:

Fig. 1 is the equivalent circuit of the best circuit illustrating the currents involved; and

Fig. 2 is a block diagram of a preferred system of the present invention.

Specific description of the invention

Fig. 1 has been discussed above and in the parent United States Patent Cooperation Treaty application.

Apparatus to perform the measurement in the manner described is shown in fig. 2.

The microprocessor 13 is the central element of the instrument. Its functions include sequencing of the test, switching signal paths, controlling the elapsed timer clock, gathering data, performing all necessary mathematical manipulations, making decisions relative to the data obtained, converting the data gathered to readable English format and controlling both an output device (printer) and input device (keyboard). Together with the microprocessor 13, the memory 15 serves to store the list of actions and sequence of operations necessary to perform the test. Collectively this set of instructions is referred to herein as the instrument program. Another section of memory 15 acts as a storage area where the microprocessor 13 stores data during the test sequence for future use.

The basic test circuit is comprised of d.c. supply 1, a sense resistor (Rs) 2, and the Specimen 5 under test connected to the instrument via connections 4 and 6. The d.c. supply 1 is programmed by the microprocessor to the desired test voltage. The d.c. supply can also be switched in or out of the test circuit by the microprocessor. When the d.c. supply 1 is programmed to the desired test voltage and attached to the load at the appropriate time, current flows to the specimen 5 through the sense resistor 2. It is the magnitude of this current flow with time which provides the data to solve for true insulation resistance, the object of the apparatus. To measure the value of this current, $I_{TOT}{}'$ a voltage sense and level shift amplifier 3 is attached across the sense resistor. This amplifier has a high impedance input so that the effect of loading upon the sense resistor 2 is negligable with regard to circuit operation. By ohms law the voltage across the resistor is inversely proportional to the current flowing through the sense resistor 2. The voltage sensor portion of device 3 measures this voltage and amplifies it with a gain which is set by the microprocessor 13 to provide the widest dynamic range and best resolution possible for the specimen being tested. Since neither side of the sense resistor 2 is at ground potential, the resultant amplified signal generated by the voltage sense portion of 3 is also not ground referenced. In fact, the signal may be at a potential of several thousands volts removed from ground. The operator safety considerations, and ease of construction of the rest of the instrument, a level shift is incorporated to move the differentially generated $I_{TOT}$ signal to a ground referenced $I_{TOT}$ which is the second function of the voltage sense and level shift amplifier 3.

The algorithm based on the foregoing mathematical analysis and employed in the embodiment requires that the solution to the equations is based upon the value of $I_{TOT}{}'$ (the derivative of $I_{TOT}$). For this reason the signal path exiting amplifier 3 is split in two. One path of the $I_{TOT}$ signal is fed into an analog to digital converter (A/D) 7 which is under microprocessor 13 control and can convert the magnitude of $I_{TOT}$ to a digital form (numerical value) for use within the microprocessor. The other path of the $I_{TOT}$ signal is fed to a differentiator (d/dt) 8 which produces the desired differentiated signal $I_{TOT}{}'$. The gain of the differentiator 8 described in the algorithm as the quantity K is controlled by the microprocessor 13 to ensure that the differentiator 8 has ample dynamic range and resolution to ensure high accuracy results. The $I_{TOT}{}'$ signal path feeds both the sample/hold memory 9 and one side of the comparator 11. The algorithm describes the need to measure the elapsed time it takes the $I_{TOT}{}'$ signal magnitude to drop in magnitude by half. The sample/hold memory 9 is used to store, by analog means, the initial value of $I_{TOT}{}'$. The state of the sample/hold memory 9 is controlled by the microprocessor 13. When in the sample mode, the output of the sample/hold memory simply follows or tracks the input magnitude. When the microprocessor 13 switches the sample/hold memory 9 into the hold mode, the output value is held constant so that it no longer tracks the input signal. This is accomplished by trapping voltage on a capacitor by using a very high impedance buffer and a switch. The output of the sample/hold memory 9 retains or stores the magnitude of what the $I_{TOT}{}'$ signal was at the instant in time when the sample/hold memory 9 was instructed to hold. The precision voltage divider 10 establishes an output of 0.5 times the input value and places this signal into the second side of comparator 11 for comparison with the instanteous value of $I_{TOT}{}'$ (stored). The time it takes for the $I_{TOT}{}'$ signal to drop in magnitude by 50% as described in the algorithm is measured by an elapsed time counter 12. The microprocessor 13 gathers such elapsed time data from the elapsed time counter 12 via signal path 16.

The microprocessor 13, and the associated memory 15 are programmed to compute

$$n = (-\log 0.5/\log T) - 1.0$$

and from this

4

$$i_c = \frac{I_{TOT}(T=10) - 10^{-n}(I_{TOT}(T=1))}{1 - 10^{-n}}$$

This value may then be displayed on the display of display and controls 14, either as an analog or digital display or directly printed by a printer or any other convenient method of indicating the result. Display and controls 14 also incorporates controls to permit the operator to control the ranges and other settings of the apparatus. Since the value of $i_c$ and $E_S$ are both known, the microprocessor 13 can be programmed to calculate the true insulation resistance value. This value can be displayed on display 14 in place of or in addition to the value of $i_c$.

Since the apparatus can measure and store values of $I_{TOT}$, it is also possible to measure the value of apparent insulation resistance, which is the "insulation resistance" measured by conventional megohmmeters such as the "Megger"® range of insulation testers made by the James G. Biddle Co. of Blue Bell, PA. Thus, it is possible for the operator to determine both the true value of insulation resistance and the apparent value as measured by the previous state of the art. This capability is useful to enable comparisons to be made with historical data.

It is also possible, when using this apparent insulation resistance mode, to pre-program the d.c. supply and to perform time dependent and step voltage or ramp voltage tests and to calculate polarization index as described in the previously references book 22T1.

It will be understood by those skilled in the art that conventional data processing equipment is used in conventional ways in the practice of the present invention.

**Claims**

1. Apparatus for calculating leakage current $i_c$ as a measure of insulation resistance for an insulation specimen (5) comprising:
   means (3) for sensing voltage across a sensing impedance (2) in circuit with a voltage supply (1) and an insulation specimen (5) to generate a signal representative of total insulation current $I_{TOT}$,
   means (7) transforming the total insulation current signal into digital form,
   means (8) differentiating with respect to time the total insulation current to produce a first derivative signal,
   sample means (9, 10) to select and hold an instantaneous fixed value of said first derivative signal and to obtain a predetermined proportion R of the fixed first derivative signal,
   comparator means (11) for receiving and comparing said predetermined proportion R of said first fixed derivation signal with the first derivative signal,
   an elapsed time computer (72) which receives an output from the comparator (11) enabling measurement from the time Z of sample taking to the time the compared signals are equal,
   a means (13) for receiving elapsed time information to calculate a constant n in accordance with the following formula

$$n = (-\log R / \log(Z/X)) - 1.0$$

and for applying the constant to the digital representation of total insulation current and for calculating leakage current using the following formula

$$i_c = \frac{Y^{-n}(I_{TOT}(T=X)) - X^{-n}(I_{TOT}(T=Y))}{Y^{-n} - X^{-n}}$$

where X and Y are predetermined times.

2. The apparatus of claim 1 in which at least the means (13) to calculate the constant n and for calculating leakage current is provided by a microprocessor.

3. The method of calculating leakage current $i_c$ as a measure of insulation resistance in an insulation specimen comprising:
   sensing current level in the insulation specimen under analysis to produce a signal representative of total insulation current $I_{TOT}$,
   converting that total insulation current signal to digital form and feeding it to computer means,
   differentiating the total insulation current signal with respect to time,
   sampling a fixed portion of the differentiated signal at a time certain to obtain a constant fixed value signal,
   taking a predetermined portion R of the sampled constant fixed value signal,
   comparing the predetermined portion of the constant fixed value with the differentiated signal over a period of time,
   measuring the elapsed time Z required for the differential signal to reach the same value as the predetermined portion of the constant fixed value signal,

calculating an equation constant n from said elapsed time in accordance with the formula:

$$n=(-\log R/\log(Z/X))-1.0$$

and

calculating leakage current ($i_c$) within the insulation sample, using the derived n, in the following formula:

$$i_c=\frac{Y^{-n}(I_{TOT}(T=X))-X^{-n}(I_{TOT}(T=Y))}{Y^{-n}-X^{-n}}$$

where X and Y are predetermined times.

## Patentansprüche

1. Gerät zur Berechnung des Kriechstromes $i_c$ als ein Mass des Isolationswiderstandes für eine Isolationsprobe (5) mit:

Mitteln (3) zum Ablesen von Spannung an einer Leseimpedanz (2) in einer Schaltung mit einer Spannungsversorgung (1) und einer Isolationsprobe (5) zum Erzeugen eines den Isolationsgesamtstrom $I_{TOT}$ darstellenden Signals,

Mitteln (7) zum Umwandeln des Isolationsstromgesamtsignals in digitale Form,

den Isolationsgesamtstrom zeitlich differenzierende Mittel (3) zum Erzeugen eines ersten abgeleiteten Signals,

Abtastmittel (9, 10) zum Auswählen und Halten eines festen Momentanwertes des besagten ersten abgeleiteten Signals und zum Erhalten eines vorbestimmten Anteiles R des besagten ersten festen abgeleiteten Signals,

Vergleichermittel (11) zum Aufnehmen und Vergleichen besagten vorbestimmten Anteiles R des besagten ersten festen Ableitungssignals mit dem ersten abgeleiteten Signal,

einem Zeitablaufrechner (12), der von dem Vergleicher (11) ein Ausgangssignal erhält, womit von der Zeit Z der Probennahme bis zur Zeit, zu der die verglichenen Signale einander gleich sind, eine Messung durchgeführt werden kann,

Mittel (13) zum Aufnehmen der Zeitablaufinformation zum Berechnen einer Konstante n entsprechend der folgenden Formel

$$n=(-\log R/\log(Z/X))-1,0$$

und zum Anlegen der Konstante an die digitale Darstellung des Isolationsgesamtstromes und zur Berechnung des Kriechstromes unter Verwendung der folgenden Formel

$$i_c=\frac{Y^{-n}(I_{TOT}(T=X))-X^{-n}(I_{TOT}T=Y))}{Y^{-n}-X^{-n}}$$

wobei X und Y vorbestimmte Zeiten sind.

2. Gerät nach Anspruch 1, dadurch gekennzeichnet, dass mindestens die Mittel (13) zur Berechnung der Konstanten n und zur Berechnung des Kriechstromes durch einen Mikroprozessor bereitgestellt werden.

3. Verfahren zur Berechnung des Kriechstromes $i_c$ als einem Mass des Isolationswiderstandes in einer Isolationsprobe mit:

Lesen der Stromhöhe in der Isolationsprobe mit Analyse zur Erzeugung eines den Isolationsgesamtstrom $I_{TOT}$ darstellenden Signals,

Umwandeln dieses Isolationsgesamtstromsignals in Digitalform und Einspeisen desselben in Rechnermittel,

zeitlichem Differenzieren des Isolationsgesamtstromsignals,

Abtasten eines Festteils des differenzierten Signals zu einer Zeit, zu der ein konstantes Signal mit Festwert sicher erhalten werden kann,

Entnahme eines vorbestimmten Anteils R des abgetasteten konstanten Signals mit Festwert,

Vergleichen des vorbestimmten Anteiles des konstanten Festwertes mit dem differenzierten Signal über eine Zeitperiode,

Messen der abgelaufenen Zeit Z, die von dem Differenzialsignal dafür benötigt wird, denselben Wert wie der vorbestimmte Anteil des konstanten Signals mit Festwert zu erreichen,

Berechnen einer Gleichungskonstanten n aus der besagten abgelaufenen Zeit nach der Formel:

$$n=(-\log R/\log(Z/X))-1,0$$

6

und

Berechnen des Kriechstromes ($i_c$) in der Isolationsprobe mit Verwendung des abgeleiteten n in der folgenden Formel:

$$i_c = \frac{Y^{-n}(I_{TOT}(T=X)) - X^{-n}(I_{TOT}(T=Y))}{Y^{-n} - X^{-n}}$$

wobei X und Y vorbestimmte Zeiten sind.

## Revendications

1. Un appareil de calcul de courant de fuite $i_c$ comme étant une mesure de la résistance d'isolement pour une éprouvette d'isolement (5) comprenant:

un moyen (3) de détection d'une tension de part et d'autre d'une impédance de détection (2) dans un circuit avec une alimentation de tension (1) et une éprouvette d'isolement (5) de manière à générer un signal représentatif d'un courant total d'isolement $I_{TOT}$;

un moyen (7) de transformation du signal de courant total d'isolement sous forme numérique,

un moyen (8) de différentiation en fonction du temps du courant total d'isolement pour produire un premier signal dérivé,

un moyen d'échantillonnage (9, 10) pour sélectionner et mettre en attente une valeur fixe instantanée dudit premier signal dérivé et pour obtenir une proportion de consigne R dudit premier signal dérivé fixe,

un moyen de comparaison (11) pour recevoir et comparer ladite proportion de consigne R dudit premier signal de dérivation fixe avec le premier signal dérivé,

un compteur de temps écoulé (12) qui reçoit une sortie provenant du comparateur (11) permettant de mesurer le temps découlé entre l'instant Z de prise d'échantillon jusqu'à l'instant où les signaux comparés sont égaux,

un moyen (13) pour recevoir des informations de temps écoulé afin de calculer une constante n conformément à la formule suivante

$$n = (-\log R/\log(Z/X)) - 1{,}0$$

et pour appliquer la constante à la représentation numérique du courant total d'isolement et pour calculer le courant de fruite à l'aide de la formule suivante

$$i_c = \frac{Y^{-n}(I_{TOT}(T=X)) - X^{-n}(I_{TOT}(T=Y))}{Y^{-n} - X^{-n}}$$

dans laquelle X et Y sont des temps de consigne.

2. L'appareil de la revendication 1 dans lequel au moins le moyen (13) de calcul de la constante n et de calcul du courant de fuite est fourni par un microprocesseur.

3. Le procédé de calcul de courant de fuite $i_c$ comme étant une mesure de résistance d'isolement dans une éprouvette d'isolement comprenant:

la détection d'un niveau de courant dans l'éprouvette d'isolement à l'analyse, afin de produire un signal représentatif du courant total d'isolement $I_{TOT}$,

la conversion de ce signal de courant total d'isolement sous forme numérique et son entrée dans un moyen de calcul,

la différentiation du signal de courant total d'isolement en fonction du temps,

l'échantillonnage d'une partie fixe du signal différencié à un instant défini pour obtenir un signal de valeur fixe constante,

la prise d'une partie de consigne R du signal échantillonné de valeur fixe constante,

la comparaison de la partie de consigne de la valeur fixe constante avec le signal différencié sur une période,

la mesure du temps écoulé Z requis pour que le signal différentiel atteigne la même valeur que la partie de consigne du signal de valeur fixe constante,

le calcul d'une constante n d'équation, à partir du temps écoulé, conformément à la formule:

$$n = (-\log R/\log(Z/X)) - 1{,}0$$

et

le calcul d'un courant de fuite ($i_c$) dans l'échantillon d'isolement, en introduisant la valeur n calculée dans la formule:

$$i_c = \frac{Y^{-n}(I_{TOT}(T=X)) - X^{-n}(I_{TOT}(T=Y))}{Y^{-n} - X^{-n}}$$

dans laquelle X et Y sont des instants de consigne.

FIG. 1

FIG. 2